## Europäisches Patentamt
## European Patent Office · (11) Veröffentlichungsnummer : **0 086 954**
## Office européen des brevets **B1**

(12) **EUROPÄISCHE PATENTSCHRIFT**

(45) Veröffentlichungstag der Patentschrift :
16.06.87

(51) Int. Cl.⁴ : **H 05 K   7/14**

(21) Anmeldenummer : **83100456.9**

(22) Anmeldetag : **20.01.83**

(54) Werkzeug zum Herausziehen eines Elektronikeinschubes aus einem Haltegestell.

(30) Priorität : **01.02.82 DE 8202450 U**

(43) Veröffentlichungstag der Anmeldung :
**31.08.83 Patentblatt 83/35**

(45) Bekanntmachung des Hinweises auf die Patenterteilung : **16.06.87 Patentblatt 87/25**

(84) Benannte Vertragsstaaten :
**DE FR GB IT**

(56) Entgegenhaltungen :
**DE-A- 2 812 631**
**FR-A- 2 382 147**
**US-A- 2 094 779**
**US-A- 3 977 749**
**US-A- 4 223 431**
**US-A- 4 223 934**
**US-A- 4 307 510**
**IBM TECHNICAL DISCLOSURE BULLETIN, Band 24, Nr. 2, Juli 1981, Seiten 1068-1069, New York, USA, R.E. COX: "Replaceable logic card cartridge"**

(73) Patentinhaber : **Stop-Choc Schwingungstechnik GmbH & Co KG**
**Benzstrasse 42**
**D-7253 Renningen (DE)**

(72) Erfinder : **Schaefer, Lothar**
**Hummelbaum 22**
**D-7253 Renningen (DE)**

(74) Vertreter : **Ostertag, Reinhard et al**
**Patentanwälte Dr. Ulrich Ostertag Dr. Reinhard Ostertag Eibenweg 10**
**D-7000 Stuttgart 70 (DE)**

## Beschreibung

Die Erfindung betrifft ein Werkzeug zum Herausziehen eines Elektronikeinschubes aus einem Haltegestell gemäß dem Oberbegriff des Anspruches 1.

Im IBM-Technical Disclosure Bulletin, Vol. 24, Nr. 2, Juli 1981, Seiten 1068 bis 1069 ist ein kartuschenähnlich ausgebildeter Einschub offenbart, in welchem eine gedruckte Schaltung innerhalb eines Außengehäuses in Steckrichtung eines Steckverbinders verlagerbar ist, der mit einem vom Haltegestell getragenen komplementären Steckverbindungsteil zusammenarbeitet. Hierzu ist am Außengehäuse mittels eines Stiftes ein Nockenkörper gelagert, der durch einen Hebel verschwenkt werden kann und in eine Ausnehmung in der Leiterplatte der gedruckten Schaltung eingreift. Durch Verdrehen des Nockenkörpers kann der von der Leiterplatte getragene Steckverbinder auf das vom Haltegestell getragene Steckverbindungsteil zu oder von diesem weg bewegt werden.

In der DE-A1 2 812 631 ist ferner eine Mechanik zum Anbringen und Abnehmen eines Elektronikeinschubes an einem Haltegestell offenbart, bei welcher am Haltegestell Betätigungshebel um feste Achsen verschwenkbar sind, deren hakenförmige Arbeitsarme mit einer an den Elektronikeinschub angeformten Leiste zusammenarbeiten, um den Einschub aus dem Haltegestell herauszuziehen oder in dieses hineinzudrücken.

Weitere bekannte Ausziehwerkzeuge haben einen bügelförmigen Ausziehabschnitt mit einer offenen Nut, in welcher das untere Ende der Frontplatte eines Elektronikeinschubes einsitzt. Ein hiervon getrenntes, ebenfalls bügelförmiges Abstützteil ist in Betriebsstellung am Haltegestell abgestützt und lagert eine Gewindespindel, die ihrerseits den Ausziehabschnitt trägt. Durch Drehen der Gewindespindel kann der Elektronikeinschub aus dem Haltegestell herausgezogen werden.

Derartige bekannte Ausziehwerkzeuge sind fest in das Haltegestell eingebaut und können daher zwangläufig nur an solchen Stellen vorgesehen werden, bei welchen sich keine Geräteriegel befinden, die zum Hineindrücken des Elektronikeinschubes in das Haltegestell verwendet werden. In der Regel werden daher solche Ausziehwerkzeuge bei der Mitte der Frontplatte des Elektronikeinschubes angeordnet.

Die Herstellung der elektrischen Verbindungen zum dem Elektronikeinschub erfolgt über eine Mehrfachsteckverbindung, welche bei den heute üblichen Elektronikeinschüben für Flugzeuge bis zu hundert Einzelsteckverbindungen und mehr umfassen. Damit ein sicherer elektrischer Kontakt erzielt wird, ist ein guter Reibschluß zwischen den einzelnen Steckbuchsen und den einzelnen Steckkontakten erforderlich. Dies führt dazu, daß die Gesamtkraft zum Schließen und Öffnen einer Steckverbindung größenordnungsmäßig 500 N erreicht. Beim Ausüben entsprechend großer Kräfte beim Herausziehen des Einschubes kann es bei Verwendung eines nur an einer Stelle des Einschubes angreifenden Ausziehwerkzeuges zu einer Verformung der Einschubfrontplatte kommen, da die Gesamtkraft an einer einzigen Stelle eingeleitet wird, die darüber hinaus bei der Mitte der Frontplatte liegt, so daß die Frontplatte der entsprechenden Biegebelastung nur verhältnismäßig schlecht Widerstand leisten kann.

Ein weiterer Nachteil der oben beschriebenen bekannten Ausziehwerkzeuge ist der, daß sie ständig am Haltegestell bzw. am Elektronikeinschub verbleiben, was sowohl im Hinblick auf die Ausrüstungskosten als auch im Hinblick auf eine glattflächige Begrenzungsfläche der durch Haltegestell und Elektronikeinschübe gebildeten Einheit nachteilig ist.

Durch die vorliegende Erfindung soll daher ein Werkzeug zum Herausziehen eines Elektronikeinschubes aus einem Haltegestell angegeben werden, welches nur zum Herausziehen des Elektronikeinschubes angesetzt wird und ein schonendes und bequemes Lösen des Elektronikeinschubes gestattet.

Diese Aufgabe ist erfindungsgemäß gelöst durch ein Ausziehwerkzeug gemäß Anspruch 1.

Das erfindungsgemäße Ausziehwerkzeug läßt sich leicht an beliebiger Stelle von unten in einen Spalt einführen, welcher sich bei eingeschobenem Einschub zwischen der Rückseite des unteren Frontplattenendes und der Vorderseite einer Traverse des Haltegestelles erstreckt. Durch Verschwenken des Betätigungshebels drückt der Nockenkörper die Einschubfrontplatte von der Gestelltraverse weg. Da das erfindungsgemäße Werkzeug nur zum Herausziehen eines Elektronikeinschubes verwendet wird, kann es nach Lösen der Geräteriegel genau an denselben Stellen der Frontplatte angesetzt werden, an welchen auch die Geräteriegel angreifen. Dabei kann man jeweils eine genauso große Anzahl von Ausziehwerkzeugen verwenden wie Geräteriegel vorhanden sind (in der Regel zwei). Damit sind die mechanischen Beanspruchungen des Einschubes beim Herausziehen symmetrisch zu den mechanischen Beanspruchungen beim Einschieben. Werden zwei Ausziehwerkzeuge zum Herausziehen eines durch zwei Geräteriegel festgehaltenen Einschubes verwendet, so kann die Schwenkbewegung der beiden Betätigungshebel leicht vom Mechaniker synchronisiert werden, so daß der Einschub in der zugeordneten Gestellaufnahme nicht verkantet. Werden mehr als zwei Ausziehwerkzeuge verwendet, so kann man deren Bewegung leicht mechanisch koppeln, z. B. durch eine Leiste mit Sackbohrungen, in welchen die Betätigungsenden der Betätigungshebel gelenkig einsitzen.

Ein erfindungsgemäßes Ausziehwerkzeug hat in praktischer Ausführungsform eine schlanke Gestalt und läßt sich ähnlich wie ein kleinerer Schraubenzieher leicht handhaben und mittragen. Die Herstellungskosten eines erfindungsgemäßen Ausziehwerkzeuges betragen nur einen Bruchteil der bekannten Gewindespindel-Ausziehwerkzeuge, die darüber hinaus noch in erheblich größerer Anzahl beschafft werden müssen.

Vorteilhafte Weiterbildungen der Erfindung sind in Unteransprüchen angegeben.

Die Weiterbildung der Erfindung gemäß Anspruch 2 ist im Hinblick auf die Erzielung möglichst großer aktiver Oberflächen des Ausziehabschnittes und des Abstützabschnittes des Werkzeuges von Vorteil.

Ellipsenförmige Querschnitte des Nockenkörpers, wie sie im Anspruch 3 angegeben sind, sind einerseits im Hinblick auf ein einfaches Herstellen der Nockenkörper von Vorteil, da der Ellipsenquerschnitt durch maschinell leicht herstellbare Kreisabschnitte hergestellt werden kann. Außerdem erhält man bei Wahl eines ellipsenförmigen Querschnittes der Nockenkörper eine hohe mechanische Untersetzung beim Herausziehen eines Elektronikeinschubes. Damit erhält man auch insgesamt eine große Ausziehkraft zum Lösen der bei der Rückseite des Einschubes vorgesehenen Mehrfachsteckverbindung.

Die Weiterbildung der Erfindung gemäß Anspruch 4 ist im Hinblick auf eine bequeme Zweihand-Handhabung eines Paares von Werkzeugen besonders vorteilhaft.

Mit der Weiterbildung der Erfindung gemäß Anspruch 5 wird erreicht, daß die Frontplatte des Elektronikeinschubes beim Herausziehen nicht nach oben wandern kann. Eine solche Ausweichbewegung kann sonst bedingt durch dasjenige Drehmoment auftreten, welches die vom Nockenkörper erzeugte Ausziehkraft bezüglich einer parallel zur Ausziehebene und zur Einschubfrontplatte verlaufenden Achse durch die Mehrfachsteckverbindung ausübt. Die Mehrfachsteckverbindung ist nämlich in der Regel unter Abstand vom unteren Ende des Einschubes auf dessen Rückseite angeordnet.

Anstelle makroskopischer Riefen kann man zum gleichen Zwecke den Ausziehabschnitt mit einer Beschichtung versehen, die einen anisotropen Reibungskoeffizienten hat. Derartige Beschichtungen sind an sich bekannt und weisen orientierte Fasern auf.

Ein Werkzeug gemäß Anspruch 8 läßt sich mit seinem Lagerabschnitt einfach zwischen zwei Schenkel eines Lagerbügels für einen Geräteriegel einsetzen, und man erhält so auf einfache Weise eine Zwangspositionierung des freien Endes des Betätigungshebels in zur Unterkante der Einschubfrontplatte paralleler Richtung sowie eine Abstützung des freien Endes des Betätigungshebels in zur Ausziehebene senkrechter Richtung.

Mit der Weiterbildung der Erfindung gemäß Anspruch 9 wird erreicht, daß das freie Ende des Betätigungshebels leicht zwischen eine nur wenig vom Einschub weggekippte Gewindespindel eines Geräteriegels und die Unterseite der Einschubfrontplatte eingeschoben werden kann.

Die Weiterbildung der Erfindung gemäß Anspruch 10 ist im Hinblick auf ein besonders einfaches Ansetzen des Werkzeuges und im Hinblick auf ein einfaches Ausfluchten der Nockenkörperachse senkrecht zur Ausziehebene von Vorteil.

Auch die Weiterbildung der Erfindung gemäß Anspruch 11 ist im Hinblick auf ein Ansetzen des Werkzeuges an einem Einschub bei nur wenig abgeklapptem Geräteriegel von Vorteil.

Die Weiterbildung der Erfindung gemäß Anspruch 12 ermöglicht es, unter Verwendung eines Standard-Betätigungshebels Ausziehwerkzeuge mit unterschiedlich geformten Nockenkörpern herzustellen.

Aus ergometrischen Gründen ist es vorteilhaft, wenn ein Greifabschnitt des Betätigungshebels bei angesetztem Werkzeug und noch nicht gelöstem Einschub schräg geneigt zur Frontplatte des Einschubes verläuft. Mit der Weiterbildung der Erfindung gemäß Anspruch 13 erhält man ein derartiges Werkzeug, wobei man durch Umsetzen des Griffes auf dem Betätigungsende des Betätigungshebels unterschiedlichen Raumverhältnissen beim jeweiligen Einsatz Rechnung tragen kann. Je größer die Zähligkeit der Symmetrieachse von Hebelende und Aufnahme, je feiner einstellbar ist die Ausrichtung der Griffachse zum Betätigungshebel bzw. Nockenkörper.

Nachstehend wird die Erfindung and Hand von Ausführungsbeispielen unter Bezugnahme auf die beiliegende Zeichnung näher erläutert. In dieser zeigen :

Figur 1   einen vertikalen Schnitt durch einen Teil eines Gestelles für Elektronikeinschübe, wobei ein Elektronikeinschub, ein zugeordneter Geräteriegel (im gelösten Zustand) und ein Werkzeug zum Herausziehen des Elektronikeinschubes (vor Einleiten der Ausziehbewegung) gezeigt sind ;

Figur 2   eine Aufsicht auf die Anordnung nach Fig. 1 von unten, wobei die Geräteriegel der besseren Übersichtlichkeit halber weggelassen sind ;

Figur 3   einen Schnitt durch einen Nockenkörper eines Ausziehwerkzeuges längs der Linie III-III von Fig. 2, in vergrößertem Maßstab ;

Figur 4   eine Aufsicht auf ein Drehteil, aus welchem mit Riefen versehene Nockenkörper hergestellt werden können ; und

Figur 5   eine Aufsicht auf ein abgewandeltes Ausziehwerkzeug mit umsetzbarem Griff, teilweise im Schnitt.

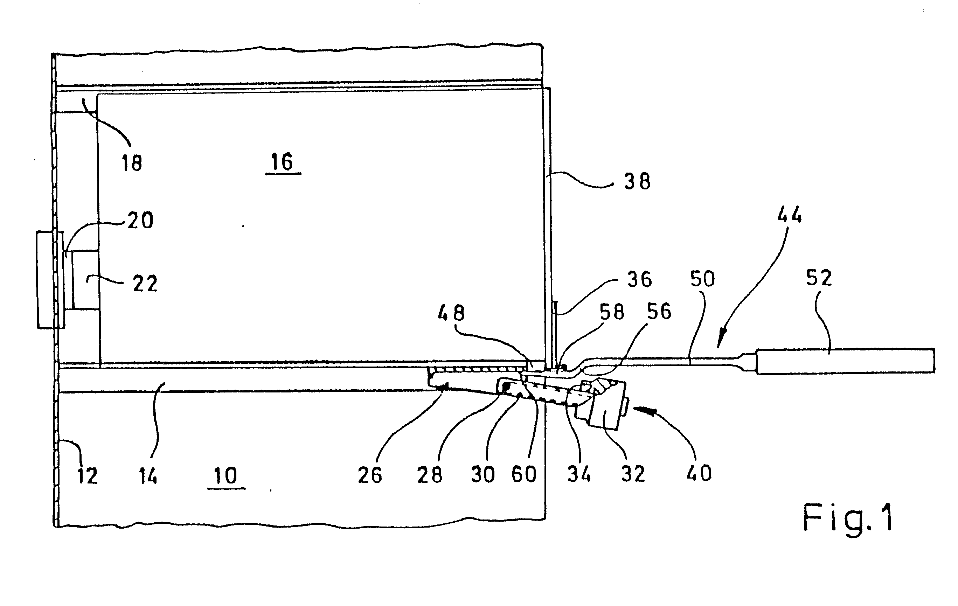

Fig. 1 zeigt einen Ausschnitt aus einem Gestell zur Aufnahme von Elektronikeinschüben mit seitlichen Gestellwänden 10 und einer hinteren Gestellwand 12. Die seitlichen Gestellwände 10 tragen horizontale Winkelschienen 14, auf welchen ein Elektronikeinschub 16 verschiebbar aufsitzt. Die dem Elektronikeinschub 16 zugeordnete Gestellaufnahme ist oben durch weitere Winkelschienen 18 begrenzt.

Zur Herstellung der notwendigen elektrischen Verbindungen zwischen dem Elektronikeinschub 16, sowie anderen Einschüben, Meßwertgebern und Verbrauchern ist eine Mehrfachsteckverbindung vorgesehen, die ein in der hinteren Gestellwand 12 befestigtes Steckverbinderteil 20 und ein hierzu komplementäres Steckverbinderteil 22 aufweist, welches von der Rückwand des Elektronikeinschubes 16 getragen ist.

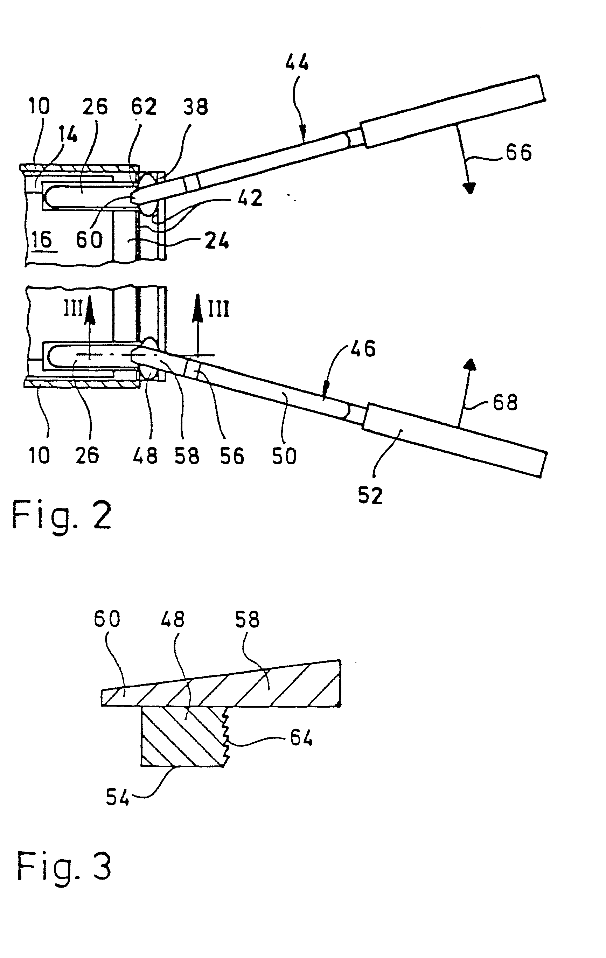

Beim vorderen unteren Ende der Einschubaufnahme weist das Gestell eine die Winkelschienen 14 verbindende weitere Winkelschiene 24 (vgl. Fig. 2) auf.

Bei den seitlichen Enden der Einschubaufnahme sind Lagerbügel 26 vorgesehen, an welchen über einen Stift 28 jeweils das eine Ende eines Gewindebolzens 30 angelenkt ist. Auf dem Gewindebolzen 30 läuft eine Spannmutter 32 mit einer einschubseitigen kegeligen Ausnehmung 34, welche zum Festspannen des Elektronikeinschubes 16 an dem abgewinkelten Endabschnitt eines Spannhakens 36 angreift, der an einer Frontplatte 38 des Elektronikeinschubes 16 befestigt ist. Der Gewindebolzen 30 und die Spannmutter 32 bilden zusammen einen Geräteriegel 40, der in Fig. 1 in gelöstem und von der Frontplatte 38 nach unten weggeklapptem Zustand gezeigt ist.

Zwischen der Rückseite der Frontplatte 38 und dem nach unten hängenden Schenkel der Winkelschiene 24 liegt ein Zwischenraum 42 (s. insbesondere Fig. 2).

Die Figuren 1 und 2 zeigen Ausziehwerkzeuge 44, 46 zum Herausziehen des Elektronikeinschubes 16 aus seiner Aufnahme unter Überwindung der Reibhemmung der Steckverbinderteile 20, 22. Die Ausziehwerkzeuge 44, 46 haben jeweils einen elliptischen Querschnitt aufweisenden Nockenkörper 48. Dessen kleine Achse entspricht der Breite des Zwischenraumes 42. Die Länge der großen Achse der Nockenkörper-Querschnittsfläche ist auf den Steckweg der Steckverbinderteile 20, 22 abgestimmt.

Die Nockenkörper 48 sind bei den freien Enden von Betätigungshebeln 50 fest angebracht, z. B. mit Hartlot befestigt, und zwar so, daß die Achse der Nockenkörper 48 senkrecht auf der Achse der Betätigungshebel 50 steht. Das zweite Ende der Betätigungshebel 50 trägt einen Kunststoffgriff 52. Der Betätigungshebel 50 hat in seinem vom Griff abgelegenen Teil rechteckigen Querschnitt, wobei die lange Seite des Rechteckes parallel zur ebenen Oberseite 54 der Nockenkörper verläuft. Der Betätigungshebel 50 weist eine in Fig. 1 nach unten verlaufende Kröpfung 56 auf, so daß der Geräteriegel 40 zum Ansetzen des Ausziehwerkzeuges nicht weit abgeklappt zu werden braucht. Der vor der Kröpfung 56 liegende Endabschnitt 58 der Betätigungshebel 50 läuft keilförmig zu, wobei ein alleräußerster Teil des Endabschnittes 58 über den Nockenkörper 48 hinausgeführt ist, wie bei 60 gezeigt. Dieser Hebelabschnitt dient zum verschwenkbaren Festlegen eines Betätigungshebels 50 zwischen den vertikal nach unten hängenden seitlichen Schenkeln eines Lagerbügels 26. Der Lagerabschnitt 60 der Betätigungshebel 50 hat somit eine dem Abstand der Lagerbügelschenkel zugeordnete Breite und ist mit seitlichen Anfasungen 62 oder Abrundungen versehen.

Wie Fig. 3 zeigt, ist die griffseitige Hälfte der Mantelfläche der Nockenkörper 48 mit sägezahnartigen Riefen 64 versehen, welche in Richtung von der Oberseite 54 der Nockenkörper 48 zum Betätigungshebel 50 hin sanft ansteigen und scharf zurückspringen.

Zum Lösen eines Elektronikeinschubes 16 werden die Ausziehwerkzeuge 44, 46 nach Lösen der Geräteriegel 40 wie in den Figuren 1 und 2 gezeigt mit ihren Lagerabschnitten 60 in die Lagerbügel 26 eingeführt und so gedreht, daß die Nockenkörper 48 in den Zwischenraum 42 einsitzen. Durch Verschwenken der Betätigungshebel 50 im Sinne der Pfeile 66, 68 werden die Nockenkörper 48 um ihre Achse gedreht und drücken hierbei die Frontplatte 38 von der Winkelschiene 24 mit großer Kraft weg. Obwohl durch diese Ausziehkraft ein Drehmoment (in Fig. 1 im Uhrzeigersinne gerichtet) ausgeübt wird, kann der Elektronikeinschub 16 in seiner Aufnahme nicht verkanten, da er durch die Riefen 64 zurückgehalten wird und der Lagerabschnitt 60 der Ausziehwerkzeuge 44, 46 am zugeordneten Lagerbügel 26 vertikal abgestützt ist. Der Elektronikeinschub 16 kann so leicht unter symmetrischer mechanischer Beanspruchung gelöst werden.

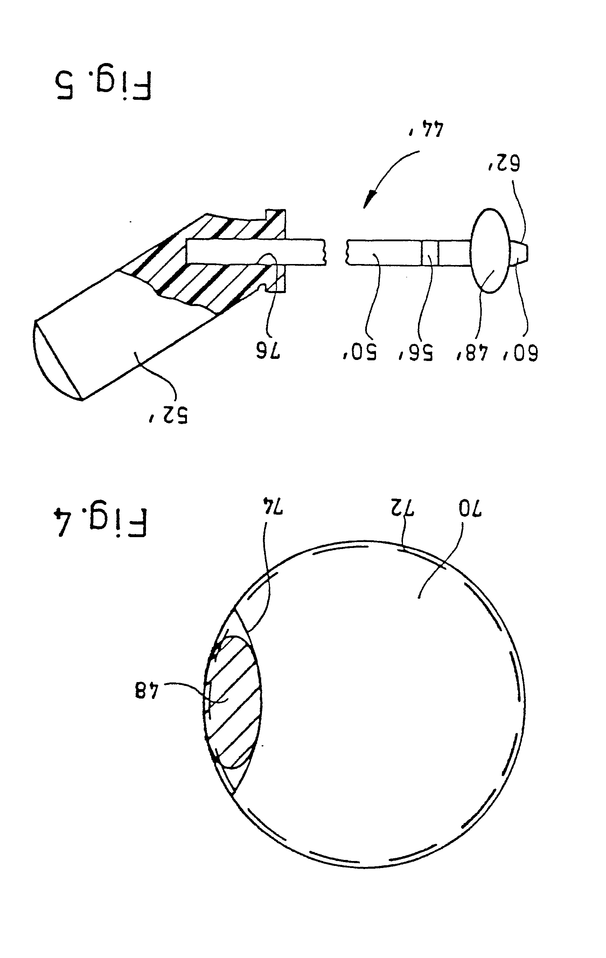

Fig. 4 zeigt eine axiale Aufsicht auf ein Drehteil 70, welches in seiner Mantelfläche mit sägezahnartigen Riefen 72 versehen ist. Durch Sägen längs einer Kreislinie 74 mit gleichem Radius wie das Drehteil 70 können aus dem letzteren mehrere linsenförmige Rohlinge hergestellt werden, aus denen man dann durch Abrunden der Spitzen einen schraffiert abgehobenen Nockenkörper 48 erhält. Man kann auf diese Weise mit sehr scharfen Riefen 64 versehene Nockenkörper 48 sehr einfach herstellen.

Fig. 5 zeigt ein abgewandeltes Ausziehwerkzeug 44', bei welchem ein Nockenkörper 48' so auf einen Betätigungshebel 50' aufgesetzt ist, daß die große Ellipsenachse senkrecht auf der Hebelachse steht. Die aus Nockenkörper 48' und Betätigungshebel 50' gebildete Einheit ist somit noch nicht auf die Handhabung durch die rechte Hand oder die linke Hand eines Mechanikers angepaßt. Diese Anpassung erfolgt unter Verwendung eines Kunststoffgriffes 52', der eine flache rechteckige Aufnahme 76 für das ebenfalls flachen rechteckigen Querschnitt aufweisende Betätigungsende des Betätigungshebels 50' aufweist. Man kann so leicht durch Umstecken des Kunststoffgriffes 52' ein zum Arbeiten mit der rechten Hand bestimmtes Ausziehwerkzeug in ein solches zur Handhabung durch die linke Hand umbauen.

Verwendet man stattdessen einen Betätigungshebel-Endabschnitt mit quadratischem Querschnitt und eine Aufnahme 76 mit quadratischem Querschnitt, so kann man den Kunststoffgriff 52' in vier verschiedenen Stellungen auf dem Betätigungshebel 50' aufsetzen, z. B. auch in Fig. 1 nach oben ragend. Damit lassen sich auch in Bodennähe angeordnete Elektronikeinschübe sehr leicht und bequem lösen.

**Patentansprüche**

1. Werkzeug zum Herausziehen eines an seiner Rückseite mit Steckern bzw. Steckdosen versehenen Elektronikeinschubes aus einem an der entsprechenden Rückseite ebenfalls mit als Gegenstück ausgebildeten Steckdosen bzw. Steckern versehenen Haltegestell, mit einem an einer Frontplatte des Einschubes angreifenden Ausziehabschnitt und einem am Haltegestell angreifenden Abstützabschnitt sowie mit Mitteln zum Erzeugen einer Relativbewegung zwischen Frontplatte des Einschubs und Haltegestell, dadurch gekennzeichnet, daß Ausziehabschnitt und Abstützabschnitt des Werkzeugs durch einander gegenüberliegende Oberflächenabschnitte eines starren Nockenkörpers (48) gebildet sind, welcher starr mit dem freien Ende eines Betätigungshebels (50) so verbunden ist, daß die Nockendrehachse im wesentlichen senkrecht auf der Achse des Betätigungshebels (50) steht, wobei einander gegenüberliegende Oberflächenabschnitte des Nockenkörpers (48) einerseits an einem zum Haltegestell gehörenden Teil (24) und andererseits an einem diesem gegenüberliegenden Endabschnitt der Frontplatte (38) des Einschubes (16) angreifen und wobei das genannte Teil (24) des Haltegestells und der Endabschnitt der Frontplatte (38) einen Zwischenraum (42) begrenzen, dessen lichter Abstand im eingeschobenen Zustand des Einschubes wenigstens gleich der kleinsten Abmessung und kleiner als die größte Abmessung des zur Nockendrehachse senkrechten Nockenkörperquerschnitts ist.

2. Werkzeug nach Anspruch 1, dadurch gekennzeichnet, daß der Nockenkörper (48) senkrecht zu seiner Drehachse eine ebene freie Stirnfläche (54) aufweist.

3. Werkzeug nach Anspruch 1 oder 2, dadurch gekennzeichnet, daß der Nockenkörper (48) senkrecht zu seiner Drehachse einen ellipsenförmigen Querschnitt aufweist und die große Ellipsenachse mit der Achse des Betätigungshebels (50) einen größeren Winkel einschließt als die kleine Ellipsenachse.

4. Werkzeug nach Anspruch 3, dadurch gekennzeichnet, daß die kleine Ellipsenachse mit der Achse des Betätigungshebels (50) einen Winkel von 15 bis 20 Grad einschließt.

5. Werkzeug nach einem der Ansprüche 1 bis 4, dadurch gekennzeichnet, daß der Ausziehabschnitt des Nockenkörpers (48) mit in Umfangsrichtung verlaufenden scharfkantigen Riefen (64) versehen ist.

6. Werkzeug nach Anspruch 5, dadurch gekennzeichnet, daß die Riefen (64) an ihrem dem Betätigungshebel (50) zugewandten Ende jeweils scharf zurückspringen.

7. Werkzeug nach einem der Ansprüche 1 bis 4, dadurch gekennzeichnet, daß der Ausziehabschnitt eine Beschichtung trägt, welche parallel zur Nockenkörperdrehachse großen und in Umfangsrichtung des Nockenkörpers (48) kleinen Reibungskoeffizienten aufweist.

8. Werkzeug nach einem der Ansprüche 1 bis 7, dadurch gekennzeichnet, daß der Betätigungshebel (50) einen über den Nockenkörper (48) überstehenden Lagerabschnitt (60) aufweist.

9. Werkzeug nach einem der Ansprüche 1 bis 8, dadurch gekennzeichnet, daß sich der Betätigungshebel (50) zum freien Ende hin verjüngt (58).

10. Werkzeug nach einem der Ansprüche 1 bis 9, dadurch gekennzeichnet, daß zumindest ein dem Nockenkörper (48) benachbarter Endabschnitt (58) des Betätigungshebels (50) rechteckigen Querschnitt aufweist, wobei die lange Seite des Rechteckes senkrecht auf der Nockenkörperdrehachse steht.

11. Werkzeug nach einem der Ansprüche 1 bis 10, dadurch gekennzeichnet, daß ein dem Nockenkörper (48) benachbarter Endabschnitt (58) des Betätigungshebels (50) eine Kröpfung (56) aufweist und der Nockenkörper (48) auf der der Achse des Betätigungshebels (50) zugewandten Seite des gekröpften Endabschnittes (58) angeordnet ist.

12. Werkzeug nach einem der Ansprüche 1 bis 11, dadurch gekennzeichnet, daß der Nockenkörper (48) durch Löten, Schweißen oder Kleben am Betätigungshebel (50) angebracht ist.

13. Werkzeug nach einem der Ansprüche 1 bis 12, dadurch gekennzeichnet, daß ein Griff (52') auf das Betätigungsende des Betätigungshebels (50') über eine zur Griffachse geneigte Aufnahme (76) formschlüssig aufgesetzt ist, wobei der Querschnitt des Betätigungsendes des Betätigungshebels (50') und die Aufnahme (76') zumindest zweizählige Symmetrie bezüglich ihrer Achse aufweist.

**Claims**

1. Tool for withdrawing an electronic plug-in unit which is provided on its rear side with plugs or sockets, from a support frame provided on the corresponding rear side likewise with sockets or plugs constructed as a counter-part, with a withdrawing section engaging on a front plate of the plug-in unit and a support section engaging on the support frame and with means for producing a relative movement between the front plate of the plug-in unit and the support frame, characterised in that the withdrawing section and support section of the tool are formed by opposing surface sections of a rigid cam body (48), which is rigidly connected to the free end of an actuating lever (50) so that the axis of rotation of the cam is substantially at right angles to the axis of the actuating lever (50), in which case opposing surface sections of the cam body (48) engage on the one hand on a part (24) belonging to the support frame and on the other hand on an end section of the front plate (38) of the plug-in unit (16) lying opposite the latter and in which case the said part (24) of the support frame and the end section of the front plate (38) define an intermediate space (42), whereof the inside width in the inserted state of the plug-in unit is at least equal to the smallest dimension and smaller than the largest dimension of the cam body cross section at right angles to the axis of rotation of the cam.

2. Tool according to Claim 1, characterised in that the cam body (48) has a flat free end face (54) at right angles to its axis of rotation.

3. Tool according to Claim 1 or 2, characterised in that at right angles to its axis of rotation the cam body (48) has an elliptical cross section and the major axis of the ellipse encloses a larger angle with the axis of the actuating lever (50) than the small axis of the ellipse.

4. Tool according to Claim 3, characterised in that the small axis of the ellipse encloses and angle of 15° to 20° with the axis of the actuating lever (50).

5. Tool according to one of Claims 1 to 4, characterised in that the withdrawing section of the cam body (48) is provided with sharp-edged ridges (64) extending in the peripheral direction.

6. Tool according to Claim 5, characterised in that at their end facing the actuating lever (50) the ridges (64) each spring back sharply.

7. Tool according to one of Claims 1 to 4, characterised in that the withdrawing section has a coating which has a high coefficient of friction parallel to the axis of rotation of the cam body and a low coefficient of friction in the peripheral direction of the cam body (48).

8. Tool according to one of Claims 1 to 7, characterised in that the actuating lever (50) comprises a bearing section (60) projecting beyond the cam body (48).

9. Tool according to one of Claims 1 to 8, characterised in that the actuating lever (50) tapers towards the free end (58).

10. Tool according to one of Claims 1 to 9, characterised in that at least one end section (58) of the actuating lever (50) adjacent the cam body (48) has a rectangular cross section, the long side of the rectangle being at right angles to the axis of rotation of the cam body.

11. Tool according to one of Claims 1 to 10, characterised in that an end section (58) of the actuating lever (50) adjacent the cam body (48) comprises a bend (56) and the cam body (48) is located on the side of the bent end section (58) facing the axis of the actuating lever (50).

12. Tool according to one of Claims 1 to 11, characterised in that the cam body (48) is attached to the actuating lever (50) by soldering, welding or sticking.

13. Tool according to one of Claims 1 to 12, characterised in that a handle (52') is fitted in a form-locking manner to the actuating end of the actuating lever (50') by way of a socket (76) inclined with respect to the axis of the handle, the cross section of the actuating end of the actuating lever (50') and the socket (76') having at least twofold symmetry with respect to its axis.

**Revendications**

1. Outil d'extraction d'un tiroir électronique, lequel est pourvu de connecteurs mâles ou femelles à sa partie arrière, de son support, lequel est également pourvu de connecteurs mâles ou femelles du côté arrière correspondant, faisant pendant aux connecteurs mâles ou femelles du tiroir, comportant une partie d'extraction venant saisir une platine avant du tiroir et une partie d'appui venant s'insérer dans le support, ainsi qu'un moyen permettant de réaliser un mouvement relatif entre la platine avant du tiroir et le support, caractérisé en ce que la partie d'extraction et la partie d'appui de l'outil sont formées par les surfaces opposées d'une came rigide (48), laquelle est reliée rigidement à l'extrémité libre d'un levier de manœuvre (50) de manière à ce que l'axe de rotation de la came se trouve disposé substantiellement de manière perpendiculaire à l'axe du levier de manœuvre (50), où les surfaces opposées de la came (48) s'insèrent entre un élément (24) du support et une extrémité inférieure de la platine avant (38) du tiroir (16), laquelle se trouve en face dudit élément (24) du support, et où ledit élément (24) du support et ladite extrémité de la platine avant (38) définissent un espace (42) dont la largeur est au moins égale à la plus petite dimension de la section transversale de la came perpendiculaire à son axe de rotation et est plus petite que la plus grande dimension de la section transversale de la came perpendiculaire à son axe de rotation, lorsque le tiroir se trouve inséré complètement dans son support.

2. Outil suivant la revendication 1, caractérisé en ce que la came (48) présente, perpendiculairement à son axe de rotation, une face plane (54).

3. Outil suivant la revendication 1 ou 2, caractérisé en ce que la came (48) présente, perpendiculairement à son axe de rotation, une section transversale elliptique et en ce que l'angle entre le grand axe de l'ellipse et l'axe du levier de manœuvre (50) est supérieur à l'angle entre le petit axe de l'ellipse et l'axe du levier de manœuvre (50).

4. Outil suivant la revendication 3, caractérisé en ce que l'angle entre le petit axe de l'ellipse et l'axe du levier de manœuvre (50) est de 15 à 20°.

5. Outil suivant une des revendications 1 à 4, caractérisé en ce que la partie d'extraction de la came (48) est pourvue de stries (64) présentant des arêtes vives dans le sens périphérique.

6. Outil suivant la revendication 5, caractérisé en ce que les stries (64), à leurs extrémités orientées vers le levier de manœuvre (50), sont très prononcées.

7. Outil suivant une des revendications 1 à 4, caractérisé en ce que la partie d'extraction possède un revêtement, lequel présente un coefficient de frottement important de manière parallèle à l'axe de rotation de la came et un faible coefficient de frottement dans le sens périphérique de la came (48).

8. Outil suivant une des revendications 1 à 7, caractérisé en ce que le levier de manœuvre (50) présente une partie d'appui (60) se prolongeant au-delà de la came (48).

9. Outil suivant une des revendications 1 à 8, caractérisé en ce que le levier de manœuvre (50) se rétrécit (58) jusqu'à son extrémité libre.

10. Outil suivant une des revendications 1 à 9, caractérisé en ce qu'au moins une partie terminale (58) du levier de manœuvre (50), voisine de la came (48), présente une section transversale rectangulaire, où le grand côté du rectangle est perpendiculaire à l'axe de rotation de la came (48).

11. Outil suivant une des revendications 1 à 10, caractérisé en ce qu'une partie terminale (58) du levier de manœuvre (50), proche de la came (48), présente une courbure (56) et en ce que la came (48) est installée sur le levier de manœuvre (50) du côté de la partie terminale (58) proche de ladite partie courbée (56).

12. Outil suivant une des revendications 1 à 11, caractérisé en ce que la came (48) est fixée par brasage, soudage ou collage sur le levier de manœuvre (50).

13. Outil suivant une des revendications 1 à 12, caractérisé en ce qu'il est ajouté de manière mécanique un manche (52') à l'extrémité de commande du levier de manœuvre (50'), suivant une cavité (76) inclinée par rapport à l'axe du manche (52'), où la section transversale de l'extrémité de commande du levier de manœuvre (50') et la cavité présentent au moins une double symétrie par rapport à leur axe.

Fig.1

0 086 954

Fig. 2

Fig. 3

Fig. 4

48

70  72  74

52'

60'  48'  56'  50'  76

62'

44'

Fig. 5